# EUROPEAN PATENT SPECIFICATION

(11) **EP 3 596 155 B1**
(45) Date of publication and mention of the grant of the patent: **03.08.2022**
(21) Application number: 18711315.4
(22) Date of filing: 14.03.2018
(51) Int. Cl.: C08G 65/40, C08J 3/00, C08K 5/00, C08G 75/20

(54) **LITHOGRAPHIC COMPOSITIONS AND METHODS OF USE THEREOF**
LITHOGRAFISCHE ZUSAMMENSETZUNGEN UND VERFAHREN ZUR VERWENDUNG DAVON
COMPOSITIONS LITHOGRAPHIQUES ET LEURS PROCÉDÉS D'UTILISATION

(30) Priority: 16.03.2017 US 201762472208 P
(43) Date of publication of application: 22.01.2020
(73) Proprietor: Merck Patent GmbH, 64293 Darmstadt (DE)
(72) Inventor: YAO, Huirong, Branchburg, New Jersey 08876 (US); WOLFER, Elizabeth, Branchburg, New Jersey 08876 (US); CHO, JoonYeon, Branchburg, New Jersey 08876 (US); POLISHCHUK, Orest, Branchburg, New Jersey 08876 (US); RAHMAN, Dalil M., Branchburg, New Jersey 08876 (US); MCKENZIE, Douglas, Branchburg, New Jersey 08876 (US)
(74) Representative: Féaux de Lacroix, Stefan
(86) International application number: PCT/EP2018/056322
(87) International publication number: WO 2018/167112

(56) References cited:
- JP-A- 2008 015 223
- JP-A- 2009 142 799
- US-A- 5 234 990
- US-A- 5 578 676
- US-B1- 6 420 514

## Description

### FIELD OF THE INVENTION

The present invention relates to compositions and methods useful for the manufacture or treatment of substrates or semiconductor devices and, in particular, to compositions and methods useful for forming layers or masks on lithographic substrates or semiconductor devices.

### BACKGROUND OF THE INVENTION

Multiple antireflective layers and hardmasks are used in advanced lithographic patterning processes. For example, in cases where a photoresist does not provide sufficient dry etch resistance, underlayers and/or antireflective coatings for the photoresist that act as a hardmask and are highly etch resistant during substrate etching are preferred. One approach has been to incorporate silicon, titanium, zirconium, aluminum, or other metallic materials into a layer beneath the organic photoresist layer. Additionally, another high carbon content antireflective or mask layer may be placed beneath the metal containing antireflective layer, to create a trilayer of high carbon film/hard mask film/photoresist. Such layers can be used to improve the lithographic performance of the imaging process. However, metal contamination in the lithographic and etch tools, as well as cross contamination between wafers during manufacturing, should be avoided.

One process and apparatus for reducing metal contamination during the manufacture of integrated circuit components has been described in US Patent No. 8,791,030 (Iwao et al). According to Iwao *et al.,* a masking composition is supplied to an edge of the substrate and baked to form a masking film at the edge of the substrate. A hardmask composition is then coated on the substrate and the masking film. The portion of the hardmask composition overlying the masking film is removed using an edge bead remover and the hardmask composition is baked to form a hardmask. The masking film is then removed with a masking film removing solution. The result is a hardmask that is spaced from the edge of the substrate, thereby reducing contamination.

JP 2008 015223 A relates to a resist underlay film forming composition containing polysulfones. The polysulfone of Example 1 has a molecular weight of 5,100. The polysulfone of Example 2 has a molecular weight of 22,800.

US 5 234 990 A relates to polymers with intrinsic light-absorbing properties for antireflective coating applications in deep ultraviolet microlithography. The polysulfone employed can have an average molecular weight of 103 to 106, see column 7, lines 39 to 41. One example of a polymer is Amoco Udel^{®} polysulfone, see column 7, lines 47 to 52. Example 1 refers to this polysulfone. However, no exact molecular weight is given.

US 5 578 676 A relates to a method for making polymers with intrinsic light-absorbing properties. The compositions can contain a polysulfone having an average molecular weight of 10³ to 106, see column 7, lines 17 to 20. An example is Amoco Udel^{®} polysulfone, see column 7, lines 26 to 45. This polysulfone is also employed according to Example 1. A specific molecular weight is not given in the example.

JP 2009 142799 A relates to a porous membrane and its manufacturing method. The polysulfone disclosed has a weight average molecular weight of 1,000 to 100,000, preferably 3,000 to 50,000, more preferably 5,000 to 30,000, see paragraph [0027]. In Comparative Example 3, again the Udel polysulfone is employed.

US 6 420 514 B1 relates to transparent polysulfone articles with reduced spurious coloration. The reference discloses polysulfones having a weight average molecular weight of at least about 10,000, preferably at least about 25,000, more preferably at least about 35,000, and most preferably up to about 200,000 or more, see column 2, lines 35 to 40. Specific polysulfone resins have an average molecular weight of 20,000 to 200,000, see column 3, lines 47 to 54. A 15 to 40 wt% solution of a polysulfone resin having a weight average molecular weight of approximately 60,000 is furthermore disclosed, see column 4, lines 7 to 11.

Accordingly, there is a need for masking compositions that can be supplied to an edge of a substrate and treated to form a masking film. In particular, it would be advantageous to provide masking compositions with properties that enable the solutions to be cast onto an edge of a substrate using, for example, spin on techniques. In addition, the masking compositions should produce masking films that do not significantly dissolve in the solvent used in the hardmask composition. Further, the masking films should not significantly dissolve in the edge bead remover. Even further, the masking films should be able to be removed without deleteriously affecting the hardmask. In particular, it would be useful for the masking films to be able to be removed by wet etching using a solvent that does not deleteriously affect the hardmask. In addition, it would be useful for the masking films to be able to be removed at a rate that enables commercially acceptable process times. The present disclosure addresses these needs.

### SUMMARY OF THE INVENTION

In one of its aspects, the present invention relates to a masking composition for forming a masking film comprising:
a. a polymer comprising a unit having structure (I): 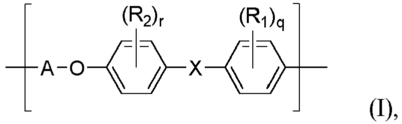 wherein
   X is selected from the group consisting of -SO₂-, -C(=O)- and -O-;
   A is a direct bond or A is selected from the group consisting of structure (II): 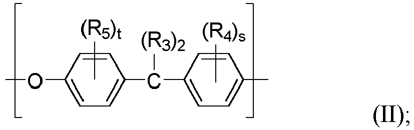
   R₁, R₂, R₃, R₄ and R₅ are each independently selected from the group consisting of H, halo, (C₁₋₃) alkyl, (C₁₋₃) fluorinated alkyl, hydroxy, (C₁₋₃) alkoxy, and (C₁₋₃) alkyl carbonyl; and
   q, r, s and t are each independently selected from the group consisting of 0, 1, 2, 3 and 4; and
b. an organic solvent,
wherein the polymer has an average molecular weight of less than 50000 and is present in the composition in an amount between 0.1 wt% and 20 wt%, and wherein the polymer comprises a mixture of polymers, wherein the mixture of polymers comprises a first polymer having an average molecular weight greater than 30000 and a second polymer having an average molecular weight less than 30000, both the first polymer and the second polymer comprising a unit having structure (I).

In another of its aspects, the present invention relates to a method of manufacturing an electronic device comprising the steps of:
a. applying the masking composition of any one of claims 1-8 onto an edge of a substrate; and
b. heating the masking composition at a temperature between 150°C and 350°C and for a time between 60 s and 120 s to form a masking film.

Preferably, the method comprises the steps of:
a. applying the masking composition of any of claims 1-8 onto an edge of a substrate
b. heating the masking composition at a temperature between 150°C and 350°C and for a time between 60 s and 120 s to form a masking film;
c. applying a hardmask composition onto the substrate and the masking film;
d. rinsing the hardmask composition with an edge bead remover to remove at least a portion of the hardmask composition that is in contact with the masking film;
e. heating the hardmask composition to form a hardmask; and
f. removing the masking film.

### BRIEF DESCRIPTION OF THE DRAWINGS

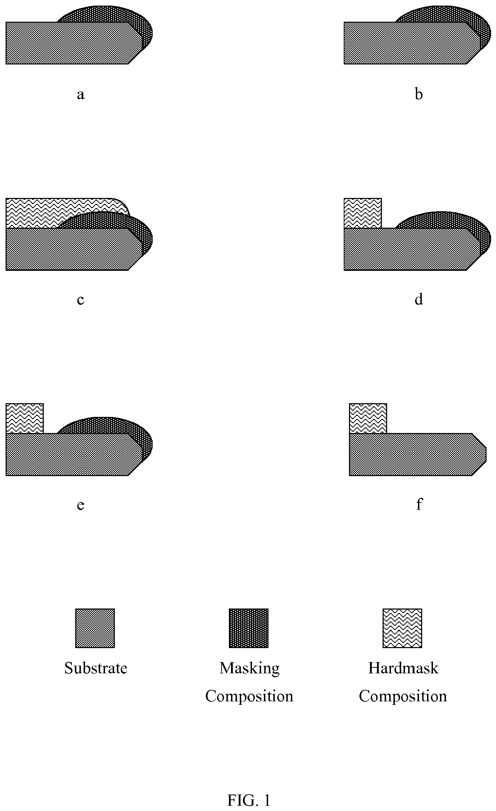

FIG. 1a-f shows a schematic representation of one embodiment of a process for using the masking compositions of the present invention. In FIG. 1a, a masking composition is applied onto an edge of a substrate. In FIG. 1b, the masking composition is heated to form a masking film. In FIG. 1c, a hardmask composition is applied onto the substrate and the masking film. In FIG. 1d, the hardmask composition is rinsed with an edge bead remover to remove at least a portion of the hardmask composition that is in contact with the masking film. In FIG. 1e, the hardmask composition is heated to form a hardmask. In FIG. If, the masking film is removed.

### DEFINITIONS

Unless otherwise stated, the following terms used in the specification and claims shall have the following meanings for the purpose of this Application.

As used herein, "C_{x-y}" designates the number of carbon atoms in a chain. For example, C₁₋₆ alkyl refers to an alkyl chain having a chain of between 1 and 6 carbons (*e.g.*, methyl, ethyl, propyl, butyl, pentyl and hexyl). Unless specifically stated otherwise, the chain can be linear or branched.

Unless otherwise indicated, alkyl refers to hydrocarbon groups which can be linear, branched (*e.g.,* methyl, ethyl, propyl, isopropyl, tert-butyl and the like), cyclic (*e.g.,* cyclohexyl, cyclopropyl, cyclopentyl and the like) or multicyclic (e.g., norbornyl, adamantly and the like). These alkyl moieties may be substituted or unsubstituted.

Fluorinated alkyl (a.k.a. Fluoroalkyl) refers to a linear, cyclic or branched saturated alkyl group as defined above in which one or more of the hydrogens have been replaced by fluorine (*e.g.*, trifluoromethyl, pefluoroethyl, 2,2,2-trifluoroethyl, prefluoroisopropyl, perfluorocyclohexyl and the like). These fluoroalkyl moieties, if not perfluorinated, may be unsubstituted or further substituted.

Alkoxy (a.k.a. Alkyloxy) refers to an alkyl group as defined above which is attached through an oxy (-O-) moiety (*e.g.*, methoxy, ethoxy, propoxy, butoxy, 1,2-isopropoxy, cyclopentyloxy, cyclohexyloxy and the like). These alkoxy moieties may be substituted or unsubstituted.

Alkyl carbonyl refers to an alkyl group as defined above which is attached through a carbonyl group (-C(=O-)) moiety (*e.g.*, methylcarbonyl, ethylcarbonyl, propylcarbonyl, buttylcarbonyl, cyclopentylcarbonyl and the like). These alkyl carbonyl moieties may be substituted or unsubstituted.

Halo or halide refers to a halogen (*e.g.,* F, Cl, Br, and I).

Hydroxy (a.k.a. Hydroxyl) refers to an -OH group.

Unless otherwise indicated, the term "substituted" when referring to an alkyl, alkoxy, fluorinated alkyl, and the like refers to one of these moieties which also contain one or more substituents, selected from the group consisting of unsubstituted alkyl, substituted alkyl, unsubstituted aryl, substituted aryl, alkyloxy, alkylaryl, haloalkyl, halide, hydroxy, amino and amino alkyl. Similarly, the term "unsubstituted" refers to these same moieties wherein no substituents apart from hydrogen are present.

### DETAILED DESCRIPTION

The masking compositions of the present invention are formed by a polymer and an organic solvent, wherein the polymer has a unit having structure (I):

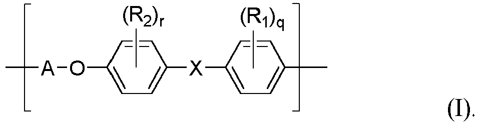

In one embodiment, X is -SO₂-. In a further embodiment, X is -C(=O)-. In another embodiment, X is -O-.

In structure (I), each R₁ is independently H, halo, (C₁₋₃) alkyl, (C₁₋₃) fluorinated alkyl, hydroxy, (C₁₋₃) alkoxy, or (C₁₋₃) alkyl carbonyl. In particular variations, each R₁ is independently H, F, or (C₁₋₃) alkyl.

In one variation, q is 0. In a further variation, q is 1. In another variation, q is 2. In still another variation, q is 3. In yet another variation, q is 4.

In structure (I), each R₂ is independently H, halo, (C₁₋₃) alkyl, (C₁₋₃) fluorinated alkyl, hydroxy, (C₁₋₃) alkoxy, or (C₁₋₃) alkyl carbonyl. In particular variations, each R₂ is independently H, F, or (C₁₋₃) alkyl.

In one variation, r is 0. In a further variation, r is 1. In another variation, r is 2. In still another variation, r is 3. In yet another variation, r is 4.

In structure (I), A can be a direct bond. Alternatively, A can have structure (II):

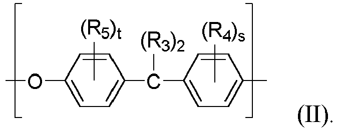

In structure (II), each R₃ is independently H, halo, (C₁₋₃) alkyl, (C₁₋₃) fluorinated alkyl, hydroxy, (C₁₋₃) alkoxy, or (C₁₋₃) alkyl carbonyl. In particular variations, each R₃ is independently H, F, (C₁₋₃) alkyl, or (C₁₋₃) fluorinated alkyl.

In structure (II), each R₄ is independently H, halo, (C₁₋₃) alkyl, (C₁₋₃) fluorinated alkyl, hydroxy, (C₁₋₃) alkoxy, or (C₁₋₃) alkyl carbonyl. In particular variations, each R₄ is independently H, F, or (C₁₋₃) alkyl.

In one variation, s is 0. In a further variation, s is 1. In another variation, s is 2. In still another variation, s is 3. In yet another variation, s is 4.

In structure (II), each R₅ is independently H, halo, (C₁₋₃) alkyl, (C₁₋₃) fluorinated alkyl, hydroxy, (C₁₋₃) alkoxy, or (C₁₋₃) alkyl carbonyl. In particular variations, each R₅ is independently H, F, or (C₁₋₃) alkyl.

In one variation, t is 0. In a further variation, t is 1. In another variation, t is 2. In still another variation, t is 3. In yet another variation, t is 4.

In one particular embodiment, the polymer has structure (III):

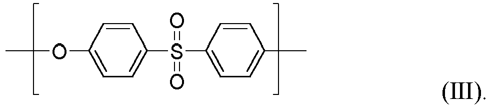

In another particular embodiment, the polymer has structure (IV):

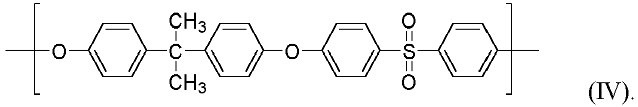

In another particular embodiment, the polymer has structure (V):

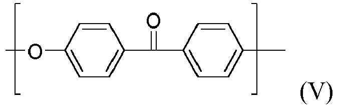

In another embodiment, the polymer has structure (VI):

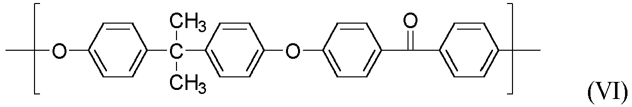

The molecular weight of the polymer can be selected to provide the desired etch rate. Toward that end, incorporation of polymers having low molecular weights will increase the etch rate. In this manner, the typically long etch times needed to process masking films which contain only polymers having high molecular weights can be beneficially reduced. Accordingly, a masking composition for forming a masking film comprising:
a. a polymer comprising a unit having structure (I): 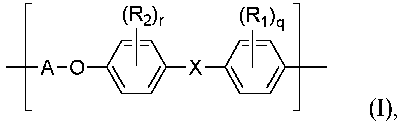 wherein
   X is selected from the group consisting of -SO₂-, -C(=O)- and -O-;
   A is a direct bond or A is selected from the group consisting of structure (II): 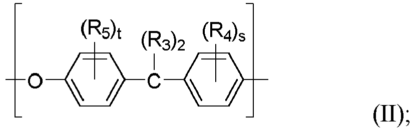
   R₁, R₂, R₃, R₄ and R₅ are each independently selected from the group consisting of H, halo, (C₁₋₃) alkyl, (C₁₋₃) fluorinated alkyl, hydroxy, (C₁₋₃) alkoxy, and (C₁₋₃) alkyl carbonyl; and
   q, r, s and t are each independently selected from the group consisting of 0, 1, 2, 3 and 4; and
b. an organic solvent,
wherein the polymer has an average molecular weight of less than 50000 and is present in the composition in an amount between 0.1 wt% and 20 wt%, and wherein the polymer comprises a mixture of polymers, wherein the mixture of polymers comprises a first polymer having an average molecular weight greater than 30000 and a second polymer having an average molecular weight less than 30000, both the first polymer and the second polymer comprising a unit having structure (I)..

However, the use of polymers with very low molecular weights can produce films that are too easily removed to be useful as masking films. Accordingly, in one embodiment, the polymer has an average molecular weight of at least 10000. In another embodiment, the polymer has an average molecular weight of at least 20000. In a further embodiment, the polymer has an average molecular weight of at least 28000. Preferably, the polymer has an average molecular weight of between 20000 and 40000, more preferably of between 28000 and 35000.

The composition comprises a mixture of polymers. The mixture of polymers comprises a first polymer having an average molecular weight greater than 30000 and a second polymer having an average molecular weight less than 30000. The first polymer can be obtained from Aldrich and the second polymer can be synthesized.

Both the first polymer and the second polymer have a unit having structure (I).

Any of a variety of organic solvents can be used in the composition. In particular, the organic solvent can be anisole, cyclohexanone, gamma butyro lactone (GBL), N-methyl-2-pyrrolidone, di-(C₁₋₆) alkyl ketones, (C₁₋₆) alkyl acetates or mixtures thereof. Specific di-(C₁₋₆) alkyl ketones include, but are not limited to, butanone, cyclopentanone, ethyl isopropyl ketone, 2-hexanone, methyl isobutyl ketone, methyl isopropyl ketone, 3-methyl-2-pentanone, 2-pentanone, 3-pentanone and mixtures thereof. Specific (C₁₋₆) alkyl acetates include, but are not limited to, methyl acetate, ethyl acetate, n-propyl acetate, isopropyl acetate, n-butyl acetate, isobutyl acetate and mixtures thereof.

It will be understood by those skilled in the art that the solid content in the composition can be adjusted based on the desired film thickness. In certain variations, the polymer is present in the composition in an amount of at least 0.1 wt%. In other variations, the polymer is present in an amount of at least 3 wt%. In certain variations, the polymer is present in an amount of not more than 20 wt%. In other variations, the polymer is present in an amount of not more than 15 wt%.

Those skilled in the art will understand that the masking compositions of the present invention can be used to form a masking film in a variety of lithographic applications. In particular, the masking compositions of the present invention can be used to form an edge protecting layer. Toward that end, the masking composition can be applied onto an edge of a substrate and then treated to form the masking film. For example, the masking compositions can be cured at a temperature between 150°C and 350°C and for a time between 60 s and 120 s. The masking composition can be applied to the substrate using any of a variety of techniques known in the art. In particular, the masking composition can be applied onto the substrate by a spin-on coating process.

More specifically, referring to FIGS. 1a-f, the masking compositions of the present invention can be used in a method of manufacturing an electronic device. A masking composition is applied onto an edge of a substrate (FIG. 1a) and treated (e.g., by the application of heat) to form a masking film (FIG. 1b). The masking composition can optionally be treated to reduce impurities prior to application. For example, the masking composition can be treated to reduce trace metal by ion exchange. A hardmask composition is then applied onto the substrate and the masking film (FIG. 1c). The masking film and hardmask composition are rinsed with an edge bead remover to remove at least a portion of the hardmask composition that is in contact with the masking film (FIG. 1d). A portion or portions of the hardmask composition that are in contact with the masking film may remain even after rinsing, provided that the portions that remain do not significantly reduce the effectiveness of the masking layer. For example, up to about 5% of the hardmask composition that is inn contact with the masking film may remain after rinsing. The hardmask composition is then treated (e.g., by the application of heat) to form a hardmask (FIG. 1e). The masking film can then be removed, leaving the hardmask spaced from the edge of the substrate (FIG. If).

The masking composition can be applied onto the substrate using any of a variety of techniques that enables the masking composition to be applied onto an edge of the substrate. One technique for applying the masking composition using a spin-on coating process is described in US Patent No. 8,791,030 (Iwao et al.)*.* In certain embodiments, the masking composition is applied in a thickness of at least 10nm, at least 50nm, at least 100nm, at least 200nm, or at least 300nm. In addition, the masking composition is applied in a thickness of up to 1000nm, up to 900nm, or up to 800nm. Further, the masking composition is applied at a width of at least 0.5mm, or at least 0.75mm. Also, the masking composition is applied at a width of not more than 1.5mm, or not more than 1.0mm. Further, the masking composition is positioned to cover the edge of the substrate and to extend over the side and/or backside of the substrate.

Those skilled in the art would readily understand that the masking composition can be treated to form the masking film using any of a variety of techniques. For example, the masking film can be heated at a temperature between 150°C and 350°C and for a time between 60 s and 120 s.

Any of a variety of known hardmask compositions can be used. In one embodiment, the hardmask composition is a metal hardmask composition. Alternatively, the hardmask composition can be a metal oxide photoresist composition. Suitable metal hardmask and metal oxide photoresist compositions include, but are not limited to, those described in US Patent Nos. 9,315,636; 8,568,958, 9,201,305; 9,296,922; 9,409,793; and 9,499,698 and US Patent Application Nos. 62/437,449 (filed December 21, 2016) and 14/978,232 (filed December 22, 2015).

Any of a variety of techniques can be used to apply the hardmask composition onto the substrate. Suitable techniques include, but are not limited to, spin-on coating, chemical vapor deposition (CVD) and atomic layer deposition (ALD). When spin coating is utilized, the solvent used should not deleteriously affect the masking film. Accordingly, suitable casting solvents for the hardmask composition include, but is not limited to, PGMEA, PGME, ethyl lactate, methoxyethanol, ethoxypropanol, ethoxyethanol, 1-pentanol, 4-methyl-2-pentanol and mixtures thereof.

Any of a variety of techniques can be used to remove a portion of the hardmask composition that is in contact with the masking film. It would be understood by those skilled in the art that removal of a portion of the hardmask composition that is in contact with the masking film should not deleteriously affect that part of the hardmask composition that is not in contact with the masking film. Suitable techniques include, but are not limited to chemical mechanical polishing (CMP), plasma etching, and wet etching. When wet etching is utilized, any of a variety of solvents (such as edge bead removers) can be used provided that the solvent does not deleteriously affect the masking film or hardmask composition. Suitable edge bead removers include, but are not limited to, PGMEA, PGME, ethyl lactate, methoxyethanol, ethoxypropanol, ethoxyethanol, 1-pentanol, 4-methyl-2-pentanol and mixtures thereof.

The hardmask composition can be treated by a variety of techniques to form the hardmask. For example, the hardmask composition can be treated by heating at a temperature between 150°C and 450°C and for a time between 60 s and 120 s.

Any of a variety of techniques can be used to remove the masking film. Suitable techniques include, but are not limited to plasma etching, and wet etching. When wet etching is utilized, any of a variety of solvents can be used provided that the solvent does not deleteriously affect the hardmask. Suitable solvents include, but are not limited to, anisole, cyclohexanone, gamma butyro lactone (GBL), N-methyl-2-pyrrolidone, di-(C₁₋₆) alkyl ketones, (C₁₋₆) alkyl acetates, aromatic hydrocarbons and mixtures thereof.

Typical electronic devices that can be manufactured using the compositions and methods of the present invention include, but are not limited to computer chips, integrated circuits, and semiconductor devices.

### EXAMPLES

Reference will now be made to more specific embodiments of the present disclosure and experimental results that provide support for such embodiments.

### Synthesis Example 1.

Bisphenol A (45.60 g, 0.20 mol), bis(p-chlorophenyl) sulfone (57.4g, 0.20 mol), dried potassium carbonate (55.3 g, 0.40mol), 400 ml of DMA (dimethyl acetamide), and 50 ml of toluene were placed in a 2L, 4 necked round bottom flask, fitted with a condenser, a nitrogen sweep, a Dean Stark trap (filled with toluene) and an overhead mechanical stirrer. The mixture was mixed at room temperature for 10 minutes.

The reaction mixture was heated at 150°C for 9.5 hours on a heating mantle. The reaction mixture was then cooled to less than 50°C and filtered through filter paper. The filtered solution (pH 9 to 10) was neutralized with 10% HCl to pH 7-6, and then poured into DI water (3200 mL) in a 5L flask. A precipitate was formed. The mixture was mixed for 30 minutes and allowed to settle overnight. Water was decanted (3400 mL) and one liter THF was added to the sticky solid. After mixing, it was transferred to a beaker and heated on a hot plate to reduce volume to one liter. The polymer was precipitated by drowning the solution into 12 liter of hexane, mixing for 1 hour, and then letting the solids settle.

The solution was filtered through filter paper and washed with hexane. Polymer was dried in a vacuum oven for two days at 80°C. Obtained 85 g, GPC Mw 9769; Pd=2.23.

The FT IR spectrum shows peaks at 1245 cm⁻¹ characteristic of the C-O-C stretch of the aryl ether group, and at 1280-1320 cm⁻¹ corresponding to the O=S=O group.

The proton NMR spectrum shows peaks at 1.7 ppm due to the aliphatic group of isopropylidene group of bisphenol-A, and at 6-7.8 ppm corresponding to the aromatic protons.

### Synthesis Example 2.

Bisphenol A (22.8g, 0.10 mole), 4,4'-Difluorobenzophenone (21.8g, 0.10 mole), potassium carbonate (27.6g, 0.20 mole), 157mL dimethylaceamide, and 21.4mL toluene was placed into a 500mL, 4 neck, round bottom flask equipped with stirring, a condenser, a thermowatch, a dean stark trap filled with toluene, and nitrogen purge. The solution was mixed at room temp for 10 minutes, and then the temp was set to 150°C. Since rflux begins at 147°C, the solution was held at reflux for 90 minutes. The solution was then cooled to < 70°C. The reaction solution was filtered to remove salts, and the filtrate was then neutralized using a small amount of 10% HCl. The polymer was precipitated by drowning the solution into 1600mL of DI water, mixing for 1 hour, and then letting the solids settle.

The water layer was poured off, and then 500mL of tetrahydrofuran was added. The solution was mixed for 30 minutes, transfered to a beaker and the volume was reduced to 600 mL on a hot plate. The polymer was precipitated by drowning into 3 liters of hexane, filtering, washing, drying, and leaving the polymer in a vacuum oven overnight. Obtain 27g, GPC Mw 54,982, Pd=1.78.

### Synthesis Example 3.

Bisphenol A (22.8g, 0.10 mole), 4,4'-Difluorobenzophenone (21.8g, 0.10 mole), potassium carbonate (27.6g, 0.20 mole), 200mL dimethylacetamide, and 27.5mL toluene was placed into a 500mL, 4 neck, round bottom flask equipped with stirring, condenser, thermowatch, dean stark trap filled with toluene, and nitrogen purge. The solution was mixed at room temp for 10 minutes, and then the temperature was set to 150°C. Since reflux begins at 147°C, the solution was held at reflux for 90 minutes. The solution was then cooled to < 70°C, filtered to remove salts, and the filtrate was then neutralize using a small amount of 10% HCl. The polymer was precipitated by drowning into 1600mL of DI water, mixing for 1 hour, and then letting the solids settle.

The water layer was poured off, and then 500mL of tetrahydrofuran was added. The solution was mixed for 30 minutes, transferred to a beaker and the volume was reduced to 600 mL on a hot plate. The polymer was precipitated by drowning into 3 liters of hexane, filtering, washing, drying, and leaving the polymer in a vacuum oven overnight. Obtain 37g, GPC Mw 15,125 Pd=2.10.

### Process Examples 1 and 2 (Reference)

Examples of masking compositions of the present invention were made and tested. Process Example 1 was prepared by dissolving 1% of the polysulfone (PSU) in anisole. Process Example 2 was prepared by dissolving 1% of the polyethersulfone (PES) in gamma butyro lactone (GBL). The masking compositions were spin coated on the edge of a wafer and baked at either 250 or 350°C for 60s to form uniform films, in accordance with the technique described in US Patent No. 8,791,030 (Iwao et al).

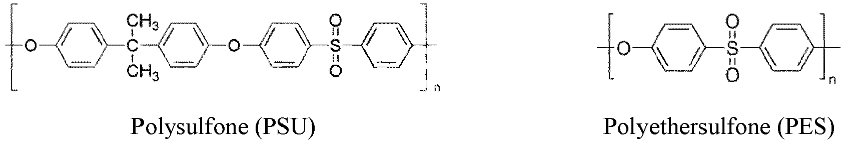

The solubilities of masking films formed from Process Examples 1 and 2 (after a 250°C/60s bake) in various solvents were investigated by measuring film loss after immersing the coated wafer in solvent for 60s. The results in Table 1 show that the masking films have good resistance to an ArF thinner solvent (PGMEA:PGME 70:30). Accordingly, there should be no intermixing between the masking films and a hardmask during processing. Further, the masking film formed from Example 1 can be removed by anisol and the masking film formed from Example 2 can be removed by GBL.

**Table 1**

| **Formulation** | **Soak Solvent** | **FT Before Soak (Å)** | **FT After Soak (Å)** | **Film Loss (Å)** | **% Film Loss** |
|---|---|---|---|---|---|
| 1% Polysulfone in Anisole | ArF Thinner | 233 | 229 | 4 | 1.71 |
| 1% Polysulfone in Anisole | Anisole | 233 | 0 | 233 | 100 |
| 1% PES in GBL | ArF Thinner | 107 | 110 | -3 | -2.80 |
| 1% PES in GBL | GBL | 107 | 0 | 107 | 100 |

The wet etch rates of masking films formed from Example 1 (after a 250°C/60s bake) were investigated in various wet etchants. The film thickness of the masking films were measured using a Nanospec 9200 and plotted as a function of soaking time of the coated wafers. The etch rates were calculated as the slope of the linear regressions. The results in Table 2 show that the polysulfone film can be removed rapidly with a baking temperature at 250°C using Fab friendly solvents. Anisole, GBL, GBL/nBA 70:30 and NMP show faster wet etch rates than cyclohexanone for the Polysulfone film.

**Table 2**

| **Solvent** | **Wet Etch Rate (Å)/sec** |
|---|---|
| Cyclohexanone | 81.50 |
| Anisole | 156.83 |
| GBL | 148.97 |
| GBL/nBA 70:30 | 154.47 |
| NMP | 151.37 |

The wet etch rates of masking films formed from Example 1 (after a 350°C/60s bake) were investigated in various wet etchants. The film thicknesses and etch rates were determined as described above. The results in Table 3 show that the Polysulfone film can be removed rapidly with a baking temperature as high as 350°C by Fab friendly solvents.

**Table 3**

| **Solvent** | **Wet Etch Rate (Å)/sec** |
|---|---|
| Cyclohexanone | 71.32 |
| Anisole | 80.85 |
| GBL | 77.53 |
| GBL/nBA 70:30 | 85.48 |
| NMP | 81.38 |

The wet etch rates of masking films formed from Example 1 (after a 250°C/60s bake) were investigated as a function of the average molecular weight of the polysulfone. The film thicknesses and etch rates were determined as described above. The data in Table 4 demonstrate that the wet etch rates can be controlled by varying the molecular weight of the Polysulfone. Specifically, lower molecular weight Polysulfones show faster wet etch rates in cyclohexanone while retaining low etch rates in ArF thinner solvent, which is beneficial for the throughput of the Polysulfone film removal process.

**Table 4**

| **MW of Polysulfone** | **Cyclohexanone Wet Etch Rate (Å/sec)** | **ArF Thinner Wet Etch Rate (Å/sec)** |
|---|---|---|
| 9848 | 616.3 | 80.0 |
| 18901 | 570.1 | 69.0 |
| 25481 | 538.5 | 51.2 |
| 28630 | 490.2 | 4.3 |
| 32386 | 476.5 | 3.3 |
| 36143 | 400.1 | 2.1 |
| 39899 | 219.5 | 1.2 |
| 47412 | 67.4 | 0.1 |

In order to demonstrate that a masking film can reduce the metal contamination, total metal contaminations on back side and bevel (Ti atoms/cm²) was analyzed by inductively coupled plasma mass spectrometry (ICP-MS). A first wafer was used without a masking layer. The edge of a second wafer was coated by a masking film which is 8.5% Polysulfone with an average molecular weight of 47412 in Anisole and baked at 250°C/60sec. Both wafers were then: (1) coated with a Ti containing metal hardmask formulation which is 9.1% Ti containing polymer synthesized as in synthesis example 7 of U.S. Patent No. 9,315,636 (Yao *et* in PGMEA/PGME=70/30, (2) rinsing the metal hardmask film on the edge of the wafer with an edge bead remover (PGMEA/PGME=30/70), (3) baking the metal hardmask film at 250°C/60sec and (4) cleaning off the masking film on the edge of wafer with Anisole . The data in table 5 show that the metal contamination in the hardmask film is reduced in the wafer treated with the masking film as compared to the wafer that was not treated with the masking film.

**Table 5**

| Spin-on Metal Oxide Hardmask Formulation | Total Metal Contamination on Back Side and Bevel (Ti atoms/cm²) | |
|---|---|---|
| | EBR (PGMEA/PGME) only without masking film | With masking film @ 250°C/60sec |
| Spin-on TiOx Hardmask | 8.5E+11 | 3.3E+9 |

### Process Examples 3

Process example 3 was prepared by dissolving 567.26g of polysulfone (obtained from Aldrich, CAS 25135-51-7) and 402.74g of the low Mw polysulfone from synthesis example 1 in 8730g of anisole.

The masking composition from process example 3 was spin coated on a silicon wafer and baked at 250°C. Then it was soaked in either ArF Thinner or cyclohexanone. The film thickness was measured before and after soak. The results are shown in Table 6.

**Table 6**

| **Formulation** | **Soak Solvent** | **FT Before Soak (Å)** | **FT After Soak (Å)** | **Film Loss (Å)** | **Wet Etch Rate Å/sec** |
|---|---|---|---|---|---|
| Process example 3 | ArF Thinner | 5416 | 5210 | 206 | 3.43 |
| Process example 3 | Cyclohexanone | 5469 | 645 | 4824 | 482.40 |

The data in Table 6 demonstrate the wet etch rate contrast in ArF Thinner and cyclohexanone.

### Process Example 4

Process example 4 was prepared by dissolving 21.170g of the polymer from synthesis example 2 and 28.830g of polymer from synthesis example 3 in 450.00g of anisole.

The masking composition from process example 4 was spin coated on a silicon wafer and baked at 250°C. Then it was soaked in either ArF Thinner or cyclohexanone. The film thickness was measured before and after soak. The results are shown in Table 7.

**Table 7**

| **Example** | **Soak Solvent** | **FT Before Soak (Å)** | **FT After Soak (Å)** | **Film Loss (Å)** | **Wet Etch Rate Å/sec** |
|---|---|---|---|---|---|
| Process example 4 | ArF Thinner | 6013 | 5963 | 53 | 0.83 |
| Process example 4 | Cyclohexanone | 6116 | 511 | 5605 | 560.50 |

The data in Table 7 demonstrate the wet etch rate contrast in ArF Thinner and cyclohexanone.

### Process Example 5 (Reference)

Process Example 3 was repeated with polysulfone (obtained from Aldrich, CAS 25135-51-7) only, and the masking composition was spin coated on a silicon wafer and baked at 250°C. Then it was soaked in either ArF Thinner or cyclohexanone. The film thickness (FT) was measured before and after soak. The results are shown in Table 8.

**Table 8**

| **Example** | **Soak Solvent** | **FT Before Soak (Å)** | **FT After Soak (Å)** | **Film Loss (Å)** | **Wet Etch Rate Å/sec** |
|---|---|---|---|---|---|
| Process Example 5 | ArF Thinner | 4923 | 5963 | -40 | -0.667 |
| Process Example 5 | Cyclohexanone | 4998 | 618 | 4280 | 87.38 |

## Claims

1. A masking composition for forming a masking film comprising:
a. a polymer comprising a unit having structure (I): 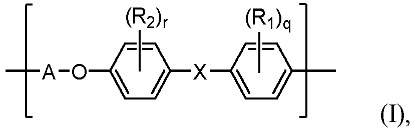 wherein
X is selected from the group consisting of -SO₂-, -C(=O)- and -O-;
A is a direct bond or A is selected from the group consisting of structure (II): 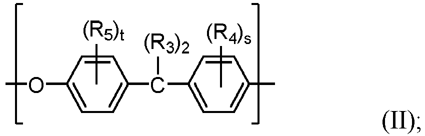
R₁, R₂, R₃, R₄ and R₅ are each independently selected from the group consisting of H, halo, (C₁₋₃) alkyl, (C₁₋₃) fluorinated alkyl, hydroxy, (C₁₋₃) alkoxy, and (C₁₋₃) alkyl carbonyl; and
q, r, s and t are each independently selected from the group consisting of 0, 1, 2, 3 and 4; and
b. an organic solvent,
wherein the polymer has an average molecular weight of less than 50000 and is present in the composition in an amount between 0.1 wt% and 20 wt%, and wherein the polymer comprises a mixture of polymers, wherein the mixture of polymers comprises a first polymer having an average molecular weight greater than 30000 and a second polymer having an average molecular weight less than 30000, both the first polymer and the second polymer comprising a unit having structure (I).

2. The composition of claim 1, wherein the polymer has an average molecular weight of between 20000 and 40000, more preferably of between 28000 and 35000.

3. The composition of any one of claims 1 or 2, having one or more of the following features:
- X is -SO₂-.
- Each R₁ is independently selected from the group consisting of H, F, and (C₁₋₃) alkyl.
- Each R₂ is independently selected from the group consisting of H, F, and (C₁₋₃) alkyl.
- Each R₃ is independently selected from the group consisting of H, F, (C₁₋₃) alkyl, and (C₁₋₃) fluorinated alkyl.
- Each R₄ is independently selected from the group consisting of H, F, and (C₁₋₃) alkyl.
- Each R₅ is independently selected from the group consisting of H, F, and (C₁₋₃) alkyl.

4. The composition of any one of claims 1-3, wherein the polymer has structure (III): 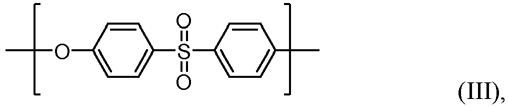 or wherein the polymer has structure (IV): 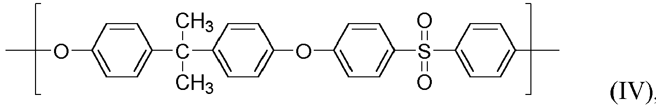 , or wherein the polymer has structure (V): 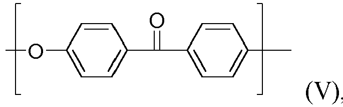 , or wherein the polymer has structure (VI):

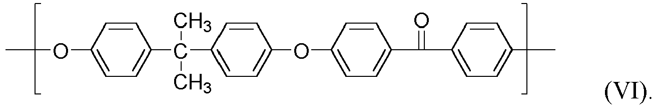

5. The composition of any one of claims 1-4, wherein the organic solvent is selected from the group consisting of anisole, cyclohexanone, gamma butyro lactone (GBL), N-methyl-2-pyrrolidone, di-(C₁₋₆) alkyl ketones, (C₁₋₆) alkyl acetates and mixtures thereof.

6. The composition of any one of claims 1-5, wherein the polymer is present in an amount between 3 wt% and 15 wt%.

7. The composition of any one of claims 1-6, wherein the organic solvent is anisole.

8. The composition of any one of claims 4-7, wherein the polymer has structure (IV):

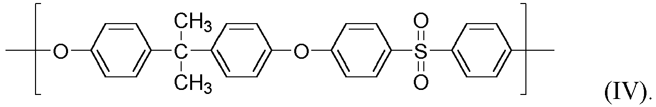

9. A method of manufacturing an electronic device comprising the steps of:
a. applying the masking composition of any one of claims 1-8 onto an edge of a substrate; and
b. heating the masking composition at a temperature between 150°C and 350°C and for a time between 60 s and 120 s to form a masking film.

10. The method of claim 9, wherein the composition is applied onto the substrate by a spin-on coating process.

11. The method of claim 9 or 10 comprising the steps of:
a. applying the masking composition of any of claims 1-8 onto an edge of a substrate
b. heating the masking composition at a temperature between 150°C and 350°C and for a time between 60 s and 120 s to form a masking film;
c. applying a hardmask composition onto the substrate and the masking film;
d. rinsing the hardmask composition with an edge bead remover to remove at least a portion of the hardmask composition that is in contact with the masking film;
e. heating the hardmask composition to form a hardmask; and
f. removing the masking film.

12. The method of claim 11, wherein the masking composition is applied onto the substrate by a spin-on coating process.

13. The method of any one of claims 11 and 12, wherein the step of heating the masking film comprises heating the masking film at a temperature between 150°C and 350°C and for a time between 60 s and 120 s.

14. The method of any one of claims 11-13, wherein the hardmask composition comprises a metal hardmask composition.

15. The method of any one of claims 11-14, wherein the hardmask composition comprises a metal oxide photoresist composition.

16. The method of any one of claims 11-15, wherein the step of applying a hardmask composition onto the substrate comprises spin coating the hardmask composition onto the substrate, wherein preferably spin coating the hardmask composition onto the substrate is conducted using a casting solvent selected from the group consisting of PGMEA, PGME, ethyl lactate, methoxyethanol, ethoxypropanol, ethoxyethanol, 1-pentanol, 4-methyl-2-pentanol and mixtures thereof.

17. The method of any one of claims 11-16, wherein the edge bead remover comprises a solvent selected from the group consisting of PGMEA, PGME, ethyl lactate, methoxyethanol, ethoxypropanol, ethoxyethanol, 1-pentanol, 4-methyl-2-pentanol and mixtures thereof.

18. The method of any one of claims 11-17, wherein the step of heating the hardmask comprises heating the hardmask at a temperature between 150°C and 450°C and for a time between 60 s and 180 s.

19. The method of any one of claims 11-18, wherein the step of removing the masking film comprises removing the masking film by wet etching, wherein wet etching is preferably conducted using a solvent selected from the group consisting of selected from the group consisting of anisole, cyclohexanone, gamma butyro lactone (GBL), N-methyl-2-pyrrolidone, di-(C₁₋₆) alkyl ketones, (C₁₋₆) alkyl acetates, aromatic hydrocarbons and mixtures thereof.

## Patentansprüche

1. Maskierungszusammensetzung zum Bilden eines Maskierungsfilms, umfassend:
a. ein Polymer, umfassend eine Einheit mit Struktur (I): 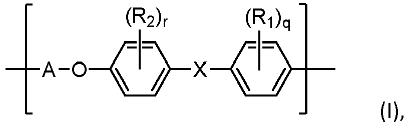 wobei
X ausgewählt ist aus der Gruppe bestehend aus -SO₂-, -C(=O)- und -O-;
A eine direkte Bindung ist oder A ausgewählt ist aus der Gruppe bestehend aus Struktur (II): 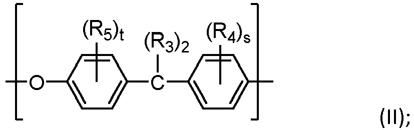
R₁, R₂, R₃, R₄ und R₅ jeweils unabhängig ausgewählt sind aus der Gruppe bestehend aus H, Halogen, (C₁₋₃)-Alkyl, fluoriertem (C₁₋₃)-Alkyl, Hydroxy, (C₁₋₃)-Alkoxy und (C₁₋₃)-Alkylcarbonyl; und
q, r, s und t jeweils unabhängig ausgewählt sind aus der Gruppe bestehend aus 0, 1, 2, 3 und 4; und
b. ein organisches Lösungsmittel,
wobei das Polymer ein durchschnittliches Molekulargewicht von weniger als 50.000 aufweist und in der Zusammensetzung in einer Menge zwischen 0,1 Gew.-% und 20 Gew.-% vorhanden ist, und wobei das Polymer eine Mischung von Polymeren umfasst, wobei die Mischung von Polymeren ein erstes Polymer mit einem durchschnittlichen Molekulargewicht größer als 30.000 und ein zweites Polymer mit einem durchschnittlichen Molekulargewicht weniger als 30.000 umfasst, sowohl das erste Polymer als auch das zweite Polymer umfassend eine Einheit mit Struktur (I).

2. Zusammensetzung nach Anspruch 1, wobei das Polymer ein durchschnittliches Molekulargewicht zwischen 20.000 und 40.000, bevorzugter zwischen 28.000 und 35.000, aufweist.

3. Zusammensetzung nach einem beliebigen der Ansprüche 1 oder 2, mit einem oder mehreren der folgenden Merkmale:
- X ist -SO₂-.
- Jedes R₁ ist unabhängig ausgewählt aus der Gruppe bestehend aus H, F und (C₁₋₃)-Alkyl.
- Jedes R₂ ist unabhängig ausgewählt aus der Gruppe bestehend aus H, F und (C₁₋₃)-Alkyl.
- Jedes R₃ ist unabhängig ausgewählt aus der Gruppe bestehend aus H, F, (C₁₋₃)-Alkyl und fluoriertem (C₁₋₃)-Alkyl.
- Jedes R₄ ist unabhängig ausgewählt aus der Gruppe bestehend aus H, F und (C₁₋₃)-Alkyl.
- Jedes R₅ ist unabhängig ausgewählt aus der Gruppe bestehend aus H, F und (C₁₋₃)-Alkyl.

4. Zusammensetzung nach einem beliebigen der Ansprüche 1-3, wobei das Polymer Struktur (III) aufweist: 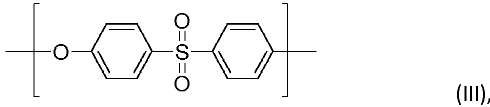 , oder wobei das Polymer Struktur (IV) aufweist: 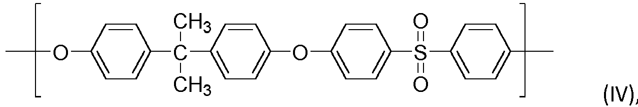 , oder wobei das Polymer Struktur (V) aufweist: 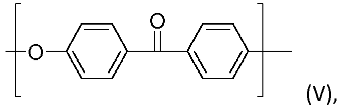 oder wobei das Polymer Struktur (VI) aufweist:

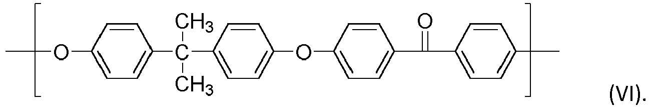

5. Zusammensetzung nach einem beliebigen der Ansprüche 1-4, wobei das organische Lösungsmittel ausgewählt ist aus der Gruppe bestehend aus Anisol, Cyclohexanon, Gamma-Butyro-Lacton (GBL), N-Methyl-2-pyrrolidon, Di-(C₁₋₆)-Alkylketonen, (C₁₋₆)-Alkylacetaten und Mischungen davon.

6. Zusammensetzung nach einem beliebigen der Ansprüche 1-5, wobei das Polymer in einer Menge zwischen 3 Gew.-% und 15 Gew.-% vorhanden ist.

7. Zusammensetzung nach einem beliebigen der Ansprüche 1-6, wobei das organische Lösungsmittel Anisol ist.

8. Zusammensetzung nach einem beliebigen der Ansprüche 4-7, wobei das Polymer Struktur (IV) aufweist:

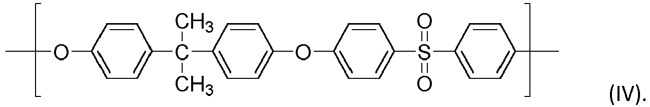

9. Verfahren zum Herstellen einer elektronischen Vorrichtung, umfassend die Schritte des:
a. Aufbringen der Maskierungszusammensetzung nach einem beliebigen der Ansprüche 1-8 auf einen Rand eines Substrats; und
b. Erhitzen der Maskierungszusammensetzung auf eine Temperatur zwischen 150 °C und 350 °C und für eine Zeit zwischen 60 s und 120 s, um einen Maskierungsfilm zu bilden.

10. Verfahren nach Anspruch 9, wobei die Zusammensetzung durch ein Aufschleuderbeschichtungsverfahren (engl.: spin-on coating process) auf das Substrat aufgebracht wird.

11. Verfahren nach Anspruch 9 oder 10 umfassend die Schritte des:
a. Aufbringen der Maskierungszusammensetzung nach einem beliebigen der Ansprüche 1-8 auf einen Rand eines Substrats
b. Erhitzen der Maskierungszusammensetzung auf eine Temperatur zwischen 150 °C und 350 °C und für eine Zeit zwischen 60 s und 120 s, um einen Maskierungsfilm zu bilden;
c. Aufbringen einer Hartmaskenzusammensetzung auf das Substrat und den Maskierungsfilm;
d. Spülen der Hartmaskenzusammensetzung mit einem Randwulstentferner (engl.: edge bead remover), um mindestens einen Teil der Hartmaskenzusammensetzung zu entfernen, der mit dem Maskierungsfilm in Kontakt ist;
e. Erhitzen der Hartmaskenzusammensetzung um eine Hartmaske zu bilden; und
f. Entfernen des Maskierungsfilms.

12. Verfahren nach Anspruch 11, wobei die Maskierungszusammensetzung durch ein Aufschleuderbeschichtungsverfahren auf das Substrat aufgebracht wird.

13. Verfahren nach einem beliebigen der Ansprüche 11 und 12, wobei der Schritt des Erhitzens des Maskierungsfilms das Erhitzen des Maskierungsfilms auf eine Temperatur zwischen 150 °C und 350 °C und für eine Zeit zwischen 60 s und 120 s umfasst.

14. Verfahren nach einem beliebigen der Ansprüche 11-13, wobei die Hartmaskenzusammensetzung eine Metall-Hartmaskenzusammensetzung umfasst.

15. Verfahren nach einem beliebigen der Ansprüche 11-14, wobei die Hartmaskenzusammensetzung eine Metalloxid-Photoresistzusammensetzung umfasst.

16. Verfahren nach einem beliebigen der Ansprüche 11-15, wobei der Schritt des Aufbringens einer Hartmaskenzusammensetzung auf das Substrat das Schleuderbeschichten (engl.: spin coating) der Hartmaskenzusammensetzung auf das Substrat umfasst, wobei bevorzugt das Schleuderbeschichten der Hartmaskenzusammensetzung auf das Substrat ausgeführt wird unter Verwendung eines Gießlösungsmittels (engl.: casting solvent), ausgewählt aus der Gruppe bestehend aus PGMEA, PGME, Ethyllactat, Methoxyethanol, Ethoxypropanol, Ethoxyethanol, 1-Pentanol, 4-Methyl-2-pentanol und Mischungen davon.

17. Verfahren nach einem beliebigen der Ansprüche 11-16, wobei der Randwulstentferner ein Lösungsmittel umfasst, ausgewählt aus der Gruppe bestehend aus PGMEA, PGME, Ethyllactat, Methoxyethanol, Ethoxypropanol, Ethoxyethanol, 1-Pentanol, 4-Methyl-2-pentanol und Mischungen davon.

18. Verfahren nach einem beliebigen der Ansprüche 11-17, wobei der Schritt des Erhitzens der Hartmaske das Erhitzen der Hartmaske auf eine Temperatur zwischen 150 °C und 450 °C und für eine Zeit zwischen 60 s und 180 s umfasst.

19. Verfahren nach einem beliebigen der Ansprüche 11-18, wobei der Schritt des Entfernens des Maskierungsfilms das Entfernen des Maskierungsfilms durch Nassätzen umfasst, wobei das Nassätzen bevorzugt unter Verwendung eines Lösungsmittels ausgeführt wird, ausgewählt aus der Gruppe bestehend aus Anisol, Cyclohexanon, Gamma-Butyro-Lacton (GBL), N-Methyl-2-pyrrolidon, Di-(C₁₋₆)-Alkylketonen, (C₁₋₆)-Alkylacetaten, aromatischen Kohlenwasserstoffen und Mischungen davon.

## Revendications

1. Composition de masquage pour la formation d'un film de masquage comprenant :
a. un polymère comprenant un motif possédant la structure (I) : 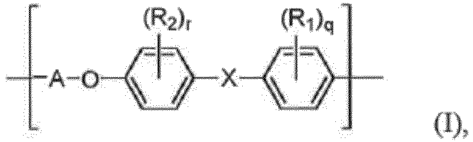
X étant choisi dans le groupe constitué par -SO₂- , -C(=O)- et -O- ;
A étant une liaison directe ou A étant choisi dans le groupe constitué par la structure (II) : 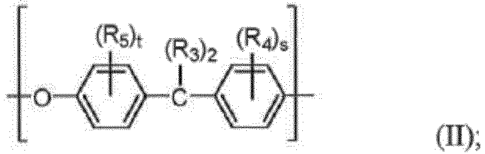
R₁, R₂, R₃, R₄ et R₅ étant chacun indépendamment choisis dans le groupe constitué par H, halogéno, (C₁₋₃) alkyle, (C₁₋₃) alkyle fluoré, hydroxy, (C₁₋₃) alcoxy, et (C₁₋₃) alkylcarbonyle ; et
q, r, s et t étant chacun indépendamment choisis dans le groupe constitué par 0, 1, 2, 3 et 4 ; et
b. un solvant organique,
le polymère possédant un poids moléculaire moyen inférieur à 50 000 et étant présent dans la composition en une quantité comprise entre 0,1 % en poids et 20 % en poids, et le polymère comprenant un mélange de polymères, le mélange de polymères comprenant un premier polymère possédant un poids moléculaire moyen supérieur à 30 000 et un deuxième polymère possédant un poids moléculaire moyen inférieur à 30 000, à la fois le premier polymère et le deuxième polymère comprenant un motif possédant la structure (I).

2. Composition selon la revendication 1, le polymère possédant un poids moléculaire moyen compris entre 20 000 et 40 000, plus préférablement entre 28 000 et 35 000.

3. Composition selon l'une quelconque des revendications 1 et 2, possédant l'une ou plusieurs des caractéristiques suivantes :
- X étant -SO₂-,
- chaque R₁ étant indépendamment choisi dans le groupe constitué par H, F et (C₁₋₃) alkyle,
- chaque R₂ étant indépendamment choisi dans le groupe constitué par H, F, et (C₁₋₃) alkyle,
- chaque R₃ étant indépendamment choisi dans le groupe constitué par H, F, (C₁₋₃) alkyle et (C₁₋₃) alkyle fluoré,
- chaque R₄ étant indépendamment choisi dans le groupe constitué par H, F et (C₁₋₃) alkyle,
- chaque R₅ étant indépendamment choisi dans le groupe constitué par H, F et (C₁₋₃) alkyle.

4. Composition selon l'une quelconque des revendications 1 à 3, le polymère possédant la structure (III) : 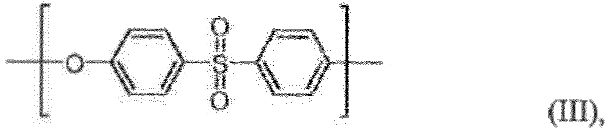 ou le polymère possédant la structure (IV) : 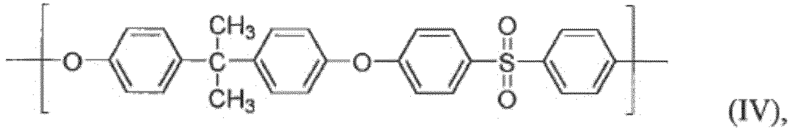 ou le polymère possédant la structure (V) : 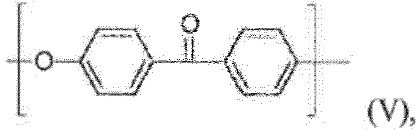 ou le polymère possédant la structure (VI) :

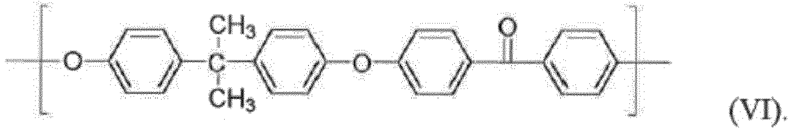

5. Composition selon l'une quelconque des revendications 1 à 4, le solvant organique étant choisi dans le groupe constitué par l'anisole, la cyclohexanone, la gamma-butyrolactone (GBL), la N-méthyl-2-pyrrolidone, des di-(C₁₋₆) alkyl-cétones, des acétates de (C₁₋₆) alkyle et des mélanges correspondants.

6. Composition selon l'une quelconque des revendications 1 à 5, le polymère étant présent en une quantité comprise entre 3 % en poids et 15 % en poids.

7. Composition selon l'une quelconque des revendications 1 à 6, le solvant organique étant l'anisole.

8. Composition selon l'une quelconque des revendications 4 à 7, le polymère possédant la structure (IV) :

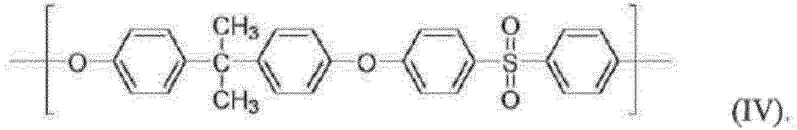

9. Procédé de fabrication d'un dispositif électronique comprenant les étapes de :
a. application de la composition de masquage selon l'une quelconque des revendications 1 à 8 sur un bord d'un substrat ; et
b. chauffage de la composition de masquage à une température comprise entre 150 °C et 350 °C et pendant une durée comprise entre 60 s et 120 s pour former un film de masquage.

10. Procédé selon la revendication 9, la composition étant appliquée sur le substrat par un procédé de revêtement par centrifugation.

11. Procédé selon la revendication 9 ou 10 comprenant les étapes de :
a. application de la composition de masquage selon l'une quelconque des revendications 1 à 8 sur un bord d'un substrat ;
b. chauffage de la composition de masquage à une température comprise entre 150 °C et 350 °C et pendant une durée comprise entre 60 s et 120 s pour former un film de masquage ;
c. application d'une composition de masque dur sur le substrat et le film de masquage ;
d. rinçage de la composition de masque dur avec un agent d'élimination de bourrelet latéral pour éliminer au moins une partie de la composition de masque dur qui est en contact avec le film de masquage ;
e. chauffage de la composition de masque dur pour former un masque dur ; et
f. élimination du film de masquage.

12. Procédé selon la revendication 11, la composition de masquage étant appliquée sur le substrat par un procédé de revêtement par centrifugation.

13. Procédé selon l'une quelconque des revendications 11 et 12, l'étape de chauffage du film de masquage comprenant le chauffage du film de masquage à une température comprise entre 150 °C et 350 °C et pendant une durée comprise entre 60 s et 120 s.

14. Procédé selon l'une quelconque des revendications 11 à 13, la composition de masque dur comprenant une composition de masque dur de métal.

15. Procédé selon l'une quelconque des revendications 11 à 14, la composition de masque dur comprenant une composition de photorésine d'oxyde métallique.

16. Procédé selon l'une quelconque des revendications 11 à 15, l'étape d'application d'une composition de masque dur sur le substrat comprenant le revêtement par centrifugation de la composition de masque dur sur le substrat, préférablement le revêtement par centrifugation de la composition de masque dur sur le substrat étant conduite en utilisant un solvant de coulage choisi dans le groupe constitué par le PGMEA, le PGME, le lactate d'éthyle, le méthoxyéthanol, l'éthoxypropanol, l'éthoxyéthanol, le 1-pentanol, le 4-méthyl-2-pentanol et des mélanges correspondants.

17. Procédé selon l'une quelconque des revendications 11 à 16, l'agent d'élimination de bourrelet latéral comprenant un solvant choisi dans le groupe constitué par le PGMEA, le PGME, le lactate d'éthyle, le méthoxyéthanol, l'éthoxypropanol, l'éthoxyéthanol, le 1-pentanol, le 4-méthyl-2-pentanol et des mélanges correspondants.

18. Procédé selon l'une quelconque des revendications 11 à 17, l'étape de chauffage du masque dur comprenant le chauffage du masque dur à une température comprise entre 150 °C et 450 °C et pendant une durée comprise entre 60 s et 180 s.

19. Procédé selon l'une quelconque des revendications 11 à 18, l'étape d'élimination du film de masquage comprenant l'élimination du film de masquage par gravure humide, la gravure humide étant préférablement conduite en utilisant un solvant choisi dans le groupe constitué par choisi dans le groupe constitué par l'anisole, la cyclohexanone, la gamma-butyrolactone (GBL), la N-méthyl-2-pyrrolidone, des di-(C₁₋₆) alkyl-cétones, des acétates de (C₁₋₆) alkyle, des hydrocarbures aromatiques et des mélanges correspondants.
